(19) Europäisches Patentamt / European Patent Office / Office européen des brevets

(11) **EP 4 556 923 B1**

(12) **EUROPEAN PATENT SPECIFICATION**

(45) Date of publication and mention
of the grant of the patent:
**15.04.2026 Bulletin 2026/16**

(21) Application number: **24213157.1**

(22) Date of filing: **15.11.2024**

(51) International Patent Classification (IPC):
***G01R 31/389*** (2019.01)

(52) Cooperative Patent Classification (CPC):
**G01R 31/389;** Y02E 60/10

(54) **BATTERY MANAGEMENT SYSTEM AND METHOD FOR CONTROLLING THE SAME**

BATTERIEVERWALTUNGSSYSTEM UND VERFAHREN ZUR STEUERUNG DAVON

SYSTÈME DE GESTION DE BATTERIE ET SON PROCÉDÉ DE COMMANDE

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**

(30) Priority: **16.11.2023 KR 20230159115**

(43) Date of publication of application:
**21.05.2025 Bulletin 2025/21**

(73) Proprietor: **SK On Co., Ltd.
Seoul 03161 (KR)**

(72) Inventors:
• **HWANG, Kyu Min
34124 Daejeon (KR)**
• **GO, Myeong Jae
34124 Daejeon (KR)**
• **KIM, Won Hee
34124 Daejeon (KR)**
• **LEE, Yun Nyoung
34124 Daejeon (KR)**
• **CHOI, So Yeon
34124 Daejeon (KR)**
• **HAN, Dong Hwa
34124 Daejeon (KR)**

(74) Representative: **Prüfer & Partner mbB
Patentanwälte · Rechtsanwälte
Sohnckestraße 12
81479 München (DE)**

(56) References cited:
WO-A1-2023/130590    CN-A- 114 502 970
CN-A- 116 798 528    KR-A- 20220 054 127
KR-A- 20240 102 764    US-A1- 2014 218 042
US-A1- 2023 324 471

• PENG YUANZHEN ET AL: "An Electrochemical
Impedance Spectroscopy-Based Model for
Lithium-Ion Batteries with Solid Phase Diffusion
Process", 2023 IEEE 2ND INTERNATIONAL
POWER ELECTRONICS AND APPLICATION
SYMPOSIUM (PEAS), IEEE, 10 November 2023
(2023-11-10), pages 887 - 891, XP034526670, DOI:
10.1109/PEAS58692.2023.10394934

**Description**

[BACKGROUND OF THE INVENTION]

1. Field of the Invention

The present disclosure relates to a battery management system and a method for controlling the same.

2. Description of the Related Art

A secondary battery is a battery that can be repeatedly charged and discharged. With rapid progress of information and communication, and display industries, the secondary battery has been widely applied to various portable electronic telecommunication devices such as a camcorder, a mobile phone, a tablet personal computer (PC), a laptop PC, etc. as a power source thereof. Recently, a battery pack including the secondary battery has also been developed as a power source of an eco-friendly automobile such as an electric vehicle.

The secondary battery includes a battery management system (BMS). The battery management system is capable of measuring and monitoring various information such as a current, voltage, temperature, state of charge (SOC), depth of discharge, state of health (SOH), and/or remaining capacity of the battery through various sensors.

Meanwhile, the battery management system can detect an abnormality of the secondary battery. For example, the battery management system may estimate an impedance of the secondary battery based on an equivalent circuit model (ECM) and detect an abnormality of the secondary battery using the estimated result. A method for estimating an impedance of the secondary battery based on the equivalent circuit model (ECM) uses a voltage response when the current changes. However, since there is no change in the current in a rest period between charge and discharge and a constant current operation section of the secondary battery, it is difficult to accurately estimate the impedance based on the equivalent circuit model (ECM) in the rest period and the constant current operation section. Due to these circumstances, there is a problem that efficiency of the method for detecting an abnormality of the secondary battery based on the ECM is reduced in terms of the utilization.

Therefore, recently, a method capable of accurately detecting an abnormality of the secondary battery in all operation sections is required. Prior art document KR20220054127A is known, which discloses an apparatus for detecting battery abnormality that includes an impedance measuring unit measuring an AC impedance of a battery module including a plurality of battery cells. The disclosed apparatus and method rely on a determination of battery module abnormality based on the AC impedance of the battery module, and may include a diagnostic unit, an alarm unit, a storage unit and a processor along with a memory.

[SUMMARY OF THE INVENTION]

According to an aspect of the present disclosure, it is an object to provide a battery management system capable of improving efficiency in abnormality detection of a secondary battery, and a method for controlling the same.

According to another aspect of the present disclosure, it is an object to provide a battery management system which may complement vulnerabilities in abnormality detection of a secondary battery based on an equivalent circuit model (ECM), and a method for controlling the same.

The battery management system and method for controlling the same of the present disclosure may be widely applied to green technology fields such as an electric vehicle, and a battery charging station, as well as other solar power generation and wind power generation using the batteries. In addition, the battery management system and method for controlling the same of the present disclosure may be used in an eco-friendly electric vehicle, and a hybrid vehicle, etc., which are intended to prevent climate change by suppressing air pollution and greenhouse gas emissions.

To achieve the above objects, according to an aspect of the present invention, there is provided a battery management system, as defined in claim 1.

According to an embodiment, the processor may be adapted to express the impedance values for each of the battery cells or battery modules as a Nyquist diagram of an orthogonal coordinate system or a polar coordinate system, and adapted to calculate the real intercepts of the impedance values for each of the battery cells or battery modules using the Nyquist diagram of the orthogonal coordinate system or the polar coordinate system.

According to an embodiment, the processor may be adapted to calculate a difference between a maximum value and a minimum value among the calculated real intercepts, and if the calculated difference is greater than a designated first reference value, adapted to determine that an abnormality has occurred in the secondary battery.

According to an embodiment, the processor may be adapted to calculate a standard deviation of the calculated real intercepts, and if the calculated standard deviation is greater than a designated second reference value, adapted to determine that an abnormality has occurred in the secondary battery.

According to an embodiment, the processor may be adapted to calculate a Z-score of the calculated real intercepts, and if the calculated Z-score is greater than a designated third reference value, adapted to determine that an abnormality has occurred in the secondary battery.

According to an embodiment, the processor may be adapted to control the EIS measurement module to measure the EIS during operation of a device including the secondary battery.

According to an embodiment, the processor may be adapted to determine whether it is in a designated operation section, wherein if it is in the designated operation section, adapted to determine whether the secondary battery is abnormal based on the calculated real intercepts, and if it is in another operation section except for the designated operation section, adapted to estimate an impedance of the secondary battery using an equivalent circuit model (ECM) estimation module, and adapted to determine whether the secondary battery is abnormal using the equivalent circuit model-based estimated result.

According to an embodiment, the EIS measurement module may be adapted to apply a variable frequency in a designated range with a designated magnitude to the secondary battery as an input signal, and adapted to measure an output signal of the secondary battery.

According to another aspect of the present invention, there is provided a method for controlling a battery management system, as defined in claim 9.

According to an embodiment, the step of calculating real intercepts may include: expressing the impedance values for the secondary battery as a Nyquist diagram of an orthogonal coordinate system or a polar coordinate system; and calculating the real intercepts of the impedance values using the Nyquist diagram of the orthogonal coordinate system or the polar coordinate system.

According to an embodiment, the step of determining whether the secondary battery is abnormal may include: calculating a difference between a maximum value and a minimum value among the calculated real intercepts; and if the calculated difference is greater than a designated first reference value, determining that an abnormality has occurred in the secondary battery.

According to an embodiment, the step of determining whether the secondary battery is abnormal may include: calculating a standard deviation of the calculated real intercepts; and if the calculated standard deviation is greater than a designated second reference value, determining that an abnormality has occurred in the secondary battery.

According to an embodiment, the step of determining whether the secondary battery is abnormal may include: calculating a Z-score of the calculated real intercepts; and if the calculated Z-score is greater than a designated third reference value, determining that an abnormality has occurred in the secondary battery.

According to an embodiment, the step of measuring an EIS may be performed during operation of a device including the secondary battery.

According to an embodiment, the step of measuring an EIS may be performed in a designated partial operation section of the operation sections of the secondary battery.

According to an embodiment, the method may further include determining whether it is in a designated operation section, wherein the step of determining whether the secondary battery is abnormal may include: if it is in the designated operation section, determining whether the secondary battery is abnormal based on the calculated real intercepts; and if it is in another operation section except for the designated operation section, estimating an impedance of the secondary battery using an equivalent circuit model (ECM) estimation module, and determining whether the secondary battery is abnormal using the equivalent circuit model-based estimated result.

According to an embodiment, the step of measuring an EIS may include applying a variable frequency in a designated range with a designated magnitude to the secondary battery as an input signal, and measuring an output signal of the secondary battery.

According to an embodiment of the present disclosure, accuracy and/or efficiency in abnormality detection of the secondary battery may be improved. For example, the present disclosure is capable of accurately and efficiently detecting the abnormality of the secondary battery based on an EIS.

In addition, the present disclosure may detect abnormalities of the secondary battery in all operation sections or a partial operation section of the secondary battery. For example, the present disclosure is capable of accurately detecting abnormalities of the secondary battery even in the rest period and the constant current operation section of the secondary battery. In other words, the present disclosure may complement vulnerabilities in abnormality detection of the method for detecting an abnormality of the secondary battery based on the equivalent circuit model (ECM).

[BRIEF DESCRIPTION OF THE DRAWINGS]

The above and other objects, features and other advantages of the present invention will be more clearly understood from the following detailed description taken in conjunction with the accompanying drawings, in which:

FIG. 1 is a block diagram illustrating the configuration of a battery management system according to an embodiment of the present disclosure;

FIG. 2 is a flowchart illustrating procedures of a method for controlling a battery management system according to an embodiment of the present disclosure;

FIG. 3A is a graphical diagram for describing a method for extracting a real intercept according to an embodiment of the present disclosure;

FIG. 3B is a graphical diagram for describing a method for extracting a real intercept according to another embodiment of the present disclosure;

FIG. 4 is a graph illustrating EIS measurement result of a plurality of cells included in a secondary battery according to an embodiment of the present disclosure; and

FIG. 5 is a flowchart illustrating procedures of a method for controlling a battery management system according to another embodiment of the present disclosure.

[DETAILED DESCRIPTION OF THE INVENTION]

Hereinafter, exemplary embodiments of the present disclosure will be described in detail with reference to the accompanying drawings. However, these embodiments are merely an example, and the present disclosure is not limited to the specific embodiments described as the example.

Although the terms first, second, etc. are used to describe various elements, components and/or sections, it will be understood that these elements, components and/or sections are not limited by these terms. These terms are merely used to distinguish one element, component or section from other elements, components or sections. Accordingly, it will be understood that the first element, first component, or first section mentioned below may also be the second element, second component, or second section within the scope of the present disclosure.

Terms used herein are for the purpose of describing particular embodiments only and are not intended to limit the present disclosure thereto. As used herein, singular forms are intended to include the plural forms as well, unless the context clearly indicates otherwise. The terms "comprises" and/or "made of" used herein in relation to the components, steps, operations and/or elements do not preclude the presence or addition of one or more other components, steps, operations and/or elements other than those mentioned.

Unless otherwise defined, all terms (including technical and scientific terms) used herein have the same meaning as commonly understood by one of ordinary skill in the art to which the present disclosure pertains. Terms, such as those defined in commonly used dictionaries, are not to be construed in an idealized or overly formal sense unless expressly so defined herein.

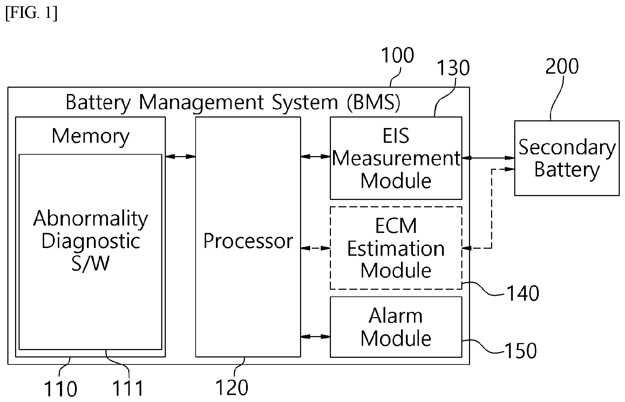

FIG. 1 is a block diagram illustrating the configuration of a battery management system according to an embodiment of the present disclosure.

Referring to FIG. 1, a battery management system 100 according to an embodiment of the present disclosure may monitor and manage a secondary battery 200. According to an embodiment, the battery management system 100 may detect whether the secondary battery 200 is abnormal and alarm an occurrence of the abnormality.

According to an embodiment, the secondary battery 200 may be charged. The secondary battery 200 may be a battery module including a plurality of battery cells or a battery pack including a plurality of battery modules. The secondary battery 200 may be included in a device (e.g., an energy storage system (ESS), an electric vehicle, etc.) driven using the power of the secondary battery 200.

According to an embodiment, the battery management system 100 may include a memory 110, a processor 120, an electrochemical impedance spectroscopy (EIS) measurement module 130, an equivalent circuit model (ECM) estimation module 140, and an alarm module 150.

The EIS measurement module 130 may apply a variable frequency (e.g., a sine wave) in a designated range (e.g., 1 Hz to 1 kHz) with a designated magnitude (e.g., 10 mV) to the secondary battery 200 (e.g., for each battery cell or battery module forming the secondary battery 200), receive an output signal of the secondary battery, and analyze the received output signal to measure an impedance change. The impedance change of the secondary battery 200 according to the measurement results of the EIS measurement module 130 may be expressed as a Nyquist plot of an orthogonal coordinate system or a polar coordinate system.

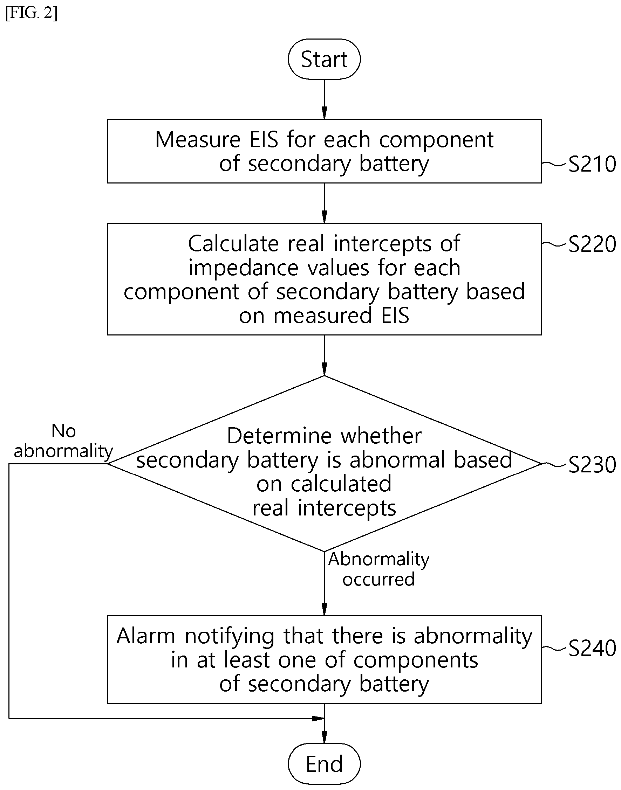

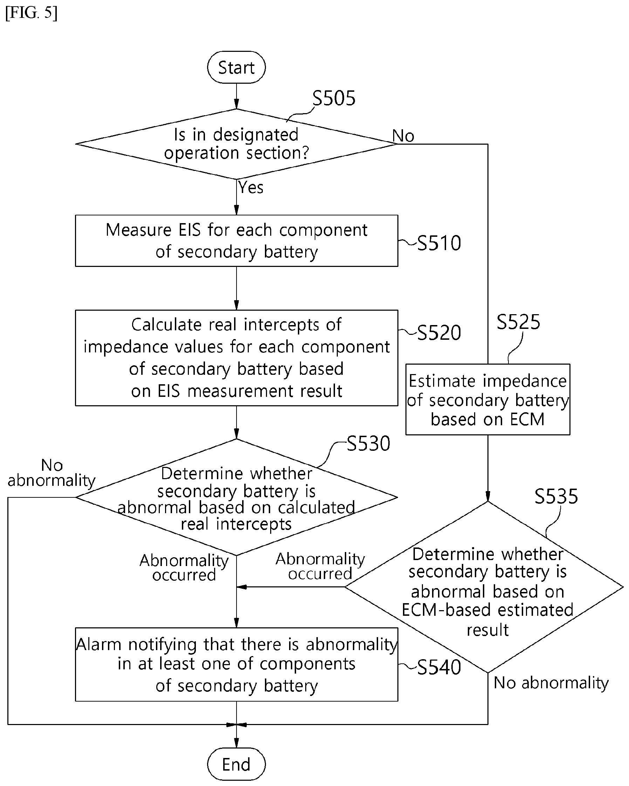

The EIS measurement module 130 may measure the EIS of the secondary battery 200 during operation of the device including the secondary battery 200 (e.g., measure the EIS for each component). The EIS measurement module 130 may perform EIS measurements during entire operation sections (e.g., the constant current operation section, composite current operation section, and rest period) (e.g., the embodiments shown in FIGS. 2 to 4) or during a partial operation section (e.g., the constant current operation section, and rest period) (e.g., the embodiment shown in FIG. 5).

The ECM estimation module 140 may estimate an impedance of the secondary battery 200 based on the ECM, and determine whether the secondary battery is abnormal based on the estimated result. According to an embodiment, the ECM estimation module 140 may be operated in some other operation sections among the entire operation sections (e.g., the constant current operation section, composite current operation section except for the rest period). Meanwhile, the ECM estimation module 140 may be omitted when determining whether the secondary battery 200 is abnormal using only the EIS measurement result (e.g., the embodiments shown in FIGS. 2 to 4).

The processor 120 may control an operation of the battery management system 100. For example, the processor 120 may receive EIS measurement result from the EIS measurement module 130, determine whether the secondary battery 200 is abnormal based on the received EIS measurement result, and if there is an abnormality in the secondary battery 200 as a result of the determination, control the alarm module 150 to provide an alarm notifying that there is an abnormality in the secondary battery 200. A specific operation of the processor 120 will be described in detail below with reference to FIGS. 2 to 4.

In addition, the processor 120 may determine whether the secondary battery 200 is abnormal in conjunction with the measurement result of the EIS measurement module 130 and the measurement result of the ECM estimation module 140 each other, and if there is an abnormality in the secondary battery 200 as a result of the determination, control the alarm module 150 to provide an alarm notifying that there is an abnormality in the secondary battery 200. A specific operation of the processor 120 will be described in detail below with reference to FIG. 5.

The memory 110 may store a program that controls the operation of the battery management system 100. In addition, the memory 110 may store information necessary to control the operation of the battery management system 100. According to an embodiment, the memory 110 may store abnormality diagnostic software 111. The abnormality diagnostic software 111 may determine whether the secondary battery 200 is abnormal based on the EIS measurement result. For example, the abnormality diagnostic software 111 may include: a routine for extracting real intercepts of impedance values for the secondary battery 200 (e.g., each component of the secondary battery 200 (e.g., the battery cells or battery modules)) based on the EIS measurement result; a routine for determining whether an abnormality has occurred based on the extracted real intercepts; and a routine for alarming an occurrence of the abnormality. In addition, the abnormality diagnostic software 111 may include a routine for determining whether the secondary battery 200 is abnormal in conjunction with the EIS measurement result and the ECM estimated result when the battery management system 100 includes the ECM estimation module 140.

The alarm module 150 may generate an alarm notifying that there is an abnormality in the secondary battery 200 (e.g., at least one of the components of the secondary battery 200 (e.g., the battery cells or battery modules)). The alarm module 150 may provide at least one of a visual alarm (e.g., light emitting diode (LED) lighting, icon display, pop-up window display, etc.), an auditory alarm (e.g., sound effect output), and a tactile alarm (e.g., vibration generation). The alarm module 150 may include at least one of a light emitting diode, a display, a speaker, and a vibration motor.

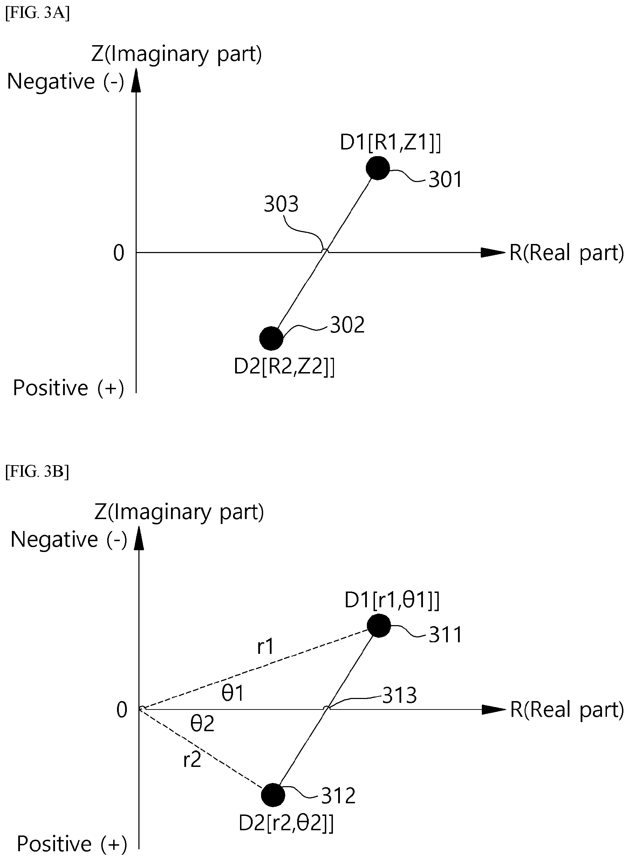

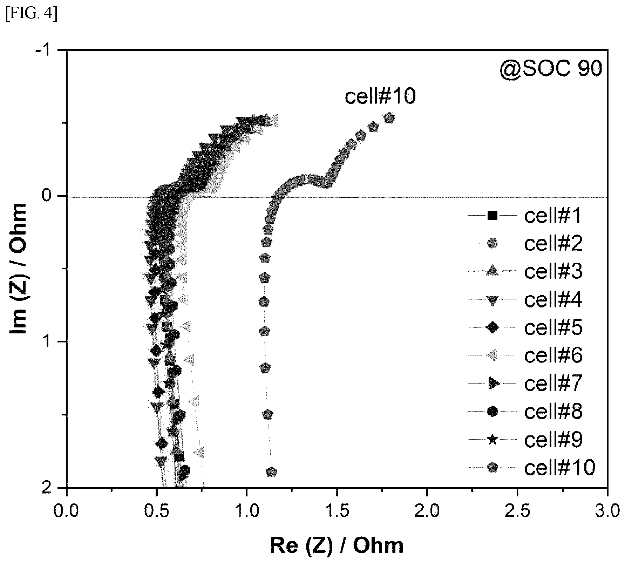

FIG. 2 is a flowchart illustrating procedures of a method for controlling a battery management system according to an embodiment of the present disclosure, FIG. 3A is a graphical diagram for describing a method for extracting a real intercept according to an embodiment of the present disclosure, FIG. 3B is a graphical diagram for describing a method for extracting a real intercept according to another embodiment of the present disclosure, and FIG. 4 is a graph illustrating EIS measurement result of a plurality of cells included in a secondary battery according to an embodiment of the present disclosure.

Referring to FIGS. 2 to 4, the method for controlling a battery management system (hereinafter, referred to as a control method) according to an embodiment of the present disclosure may include a step (S210) of measuring an EIS of a secondary battery. For example, the processor 120 of the battery management system 100 may measure an EIS for each component of the secondary battery 200 using the EIS measurement module 130. The EIS measurement module 130 may apply a variable frequency in a designated range (e.g., 1 Hz to 1 kHz) with a designated magnitude (e.g., 10 mV) to each component of the secondary battery 200 as an input signal, and measure an output signal of each component. Here, the component may be the battery cell or battery module. For example, when the secondary battery 200 is a battery module, the component is the battery cell, and when the secondary battery 200 is a battery pack, the component is the battery module.

According to an embodiment, the step of measuring EIS in step S210 may be performed during operation of a device (e.g., an energy storage system (ESS), an electric vehicle, etc.) including the secondary battery 200.

The control method may include a step (S220) of calculating real intercepts of impedance values for the secondary battery (e.g., each component of the secondary battery) based on the EIS measurement result. The real intercept may be a value related to an electrolyte resistance characteristic among the EIS measurement results. The processor 120 may express the impedance value for each component as a Nyquist plot of an orthogonal coordinate system or a polar coordinate system, and may calculate the real intercepts for each component using the Nyquist plot of the orthogonal coordinate system or the polar coordinate system. For example, when the impedance values are expressed as a Nyquist plot of the orthogonal coordinate system, the processor 120 may generate a straight line equation connecting a first point 301 having a positive minimum value and a second point 302 having a negative maximum value among imaginary parts of the impedance values, as shown in FIG. 3A, and calculate a real intercept 303 using the generated straight line equation. Here, a straight line equation Z may be generated as in <Equation 1> below, and the real intercept 303 may be calculated by <Equation 2> below.

$$\text{Straight line equation } Z = Z1 + \left(\frac{Z1-Z2}{R1-R2}\right)(R - R1) \quad \ldots\ldots < \text{Equation 1>}$$

$$\text{Real intercept } R = R1 - \left(\frac{R1-R2}{Z1-Z2}\right)(Z1) \quad \ldots\ldots < \text{Equation 2>}$$

As another example, when the impedance values are expressed as a Nyquist diagram of the polar coordinate system, as shown in FIG. 3B, the processor 120 may generate the straight line equation Z connecting the third point 311 and a fourth point 312 as <Equation 3> below, and calculate a real intercept 313 by <Equation 4> below.

$$\text{Straight line equation } Z = r1\sin\theta1 + \left(\frac{r1\sin\theta1-r2\sin\theta2}{r1\cos\theta1-r2\cos\theta2}\right)(R - r1\cos\theta1) \quad \ldots\ldots <$$

$$\text{Equation 3>}$$

$$\text{Real intercept } R = r1\cos\theta1 - \left(\frac{r1\cos\theta1-r2\cos\theta2}{r1\sin\theta1-r2\sin\theta2}\right)(r1\sin\theta1) \quad \ldots\ldots < \text{Equation 4>}$$

According to some embodiments, the processor may calculate the real intercept 303 or 313 using the coordinate values of the first point 301 or (the third point 311), the coordinate values of the second point 302 or (the fourth point 312), and a designated equation (e.g., <Equation 2> or <Equation 4>).

The control method may include a step (S230) of determining whether the secondary battery is abnormal based on the extracted real intercepts. For example, the processor 120 may calculate an index value (or a representative value) representing distribution characteristics of the extracted real intercepts, and determine whether the secondary battery is abnormal based on the calculated index value. The index value may be a difference between the maximum value and the minimum value among the real intercepts, a standard deviation of the real intercepts, or a Z-score of the real intercepts.

Specifically, the processor 120 may calculate a difference between the maximum value and the minimum value, and if the calculated difference is greater than (or equal to or greater than) a designated first reference value, determine that an abnormality has occurred in the secondary battery (e.g., at least one of the components), and if it is equal to or less than (or less than) the first reference value, determine that there is no abnormality. Alternatively, the processor 120 may calculate a standard deviation of the real intercepts, and if the calculated standard deviation is greater than (or equal to or greater than) a designated second reference value, determine that an abnormality has occurred in the secondary battery (e.g., at least one of the components), and if it is equal to or less than (or less than) the second reference value, determine that there is no abnormality. Alternatively, the processor 120 may calculate a G-score of the real intercepts, and if the calculated G-score is greater than (or equal to or greater than) a designated third reference value, determine that an abnormality has occurred in the secondary battery (e.g., at least one of the components), and if it is equal to or less than (or less than) the third reference value, determine that there is no abnormality. Here, the method for calculating the standard deviation of the real intercepts and the G-score is well known to those skilled in the art, and therefore will not be described in detail.

In other words, the processor 120 may determine whether there is an abnormality in the secondary battery based on whether the real intercepts of the impedance values of a plurality of components (e.g., the battery cells or battery modules) included in the secondary battery 200 are distributed within a predetermined range (e.g., whether the real intercepts have similar values). For example, as shown in FIG. 4, when the real intercepts of first to ninth cells (cell#1 to cell#9) are distributed within a predetermined range, that is, have similar values, whereas the real intercept of a tenth cell (cell#10) is distributed alone spaced apart from others, the processor 120 may determine that there is an abnormality in the secondary battery 200.

If there is an abnormality as a result of the determination in the step S230, the control method may proceed to a step (S240) of generating an alarm. For example, the processor 120 may control the alarm module 150 to generate an alarm notifying that there is an abnormality in at least one of the components (e.g., the battery cells or battery modules) of the secondary battery 200. The alarm may include at least one of a visual alarm (e.g., LED lighting, icon display, pop-up window display, etc.), an auditory alarm (e.g., sound effect output), and a tactile alarm (e.g., vibration generation).

On the other hand, if there is no abnormality as a result of the determination in the step S230, the control method may be ended. Thereafter, the control method may periodically repeat the above-described steps S210 to S240.

One embodiment of the present disclosure may accurately detect an abnormality of the secondary battery using the EIS measurement result. In addition, one embodiment of the present disclosure may accurately detect an abnormality of the secondary battery in the entire operation section of the secondary battery. That is, one embodiment of the present disclosure may improve the accuracy and/or efficiency in abnormality detection of the secondary battery.

One embodiment of the present disclosure may determine whether the secondary battery is abnormal based on the real intercepts (corresponding to electrolyte resistance characteristics among the EIS measurement results) related to the plurality of components forming the secondary battery. The present disclosure may determine the abnormality by reflecting differences in states (e.g., temperature, deterioration, etc.) between the components included in the secondary battery 200. Accordingly, the present disclosure may effectively (or efficiently) determine whether the secondary battery 200 is abnormal.

FIG. 5 is a flowchart illustrating procedures of a method for controlling a battery management system according to another embodiment of the present disclosure.

Referring to FIG. 5, a method for controlling a battery management system according to another embodiment of the present disclosure may include a step (S505) of determining whether it is in a designated operation section. The designated operation section may include a section where it is difficult to estimate the impedance based on the equivalent circuit model (ECM) among the entire operation sections of the secondary battery included in the electric vehicle and the energy storage system. For example, the designated operation section may include the rest period and the constant current operation section among the operation sections of the secondary battery.

If it is in the designated operation section as a result of the determination in the step S505, the control method may proceed to step S510. Thereafter, the control method may perform steps S520, S530 and S540. Here, the steps S510 to S540 are similar to the steps S210 to S240 of FIG. 2, and therefore will not be described in detail.

On the other hand, if it is not in the designated operation section as a result of the determination in the step S505, the control method may proceed to a step (S525) of estimating the impedance of the secondary battery based on the equivalent circuit model. Thereafter, the control method may perform a step (S535) of determining whether the secondary battery is abnormal based on the ECM-based estimated result. If there is an abnormality as a result of the determination in the step S535, the control method may proceed to a step S540. On the other hand, if there is no abnormality as a result of the determination in the step S535, the control method may be ended. Thereafter, the processor 120 may periodically repeat the above-described steps S505 to S540.

The above-described control method for the battery management system according to another embodiment of the present disclosure may determine whether the secondary battery is abnormal in conjunction with the EIS measurement and the equivalent circuit model-based measurement each other. That is, another embodiment of the present disclosure may complement the vulnerabilities in the method for detecting an abnormality of a secondary battery based on the equivalent circuit model that makes it difficult to estimate impedance in the rest period and the constant current operation section.

## Claims

1. A battery management system (100) comprising:

    an alarm module (130) configured to provide an alarm in a designated manner;
    an electrochemical impedance spectroscopy, EIS, measurement module (110) configured to measure an EIS of a secondary battery (10); and
    a processor (120) configured to receive an EIS measurement result from the EIS measurement module (110), calculate real intercepts of impedance values for the secondary battery (10) based on the received EIS measurement result, determine whether the secondary battery (10) is abnormal based on the calculated real intercepts, and control the alarm module (130) to provide an alarm notifying that the secondary battery (10) is abnormal if there is an abnormality in the secondary battery (10) as a result of the determination,
    wherein the EIS measurement module (110) is adapted to measure the EIS for each battery cell or battery module, and wherein the battery management system is **characterised**
    **in that** the processor (120) is adapted to select a first point having a positive minimum value and a second point having a negative maximum value among imaginary parts of the impedance values, and is adapted to calculate the real intercepts using coordinate values of the first point, coordinate values of the second point, and a designated equation.

2. The battery management system (100) according to claim 1, wherein the processor (120) is adapted to express the impedance values for each of the battery cells or battery modules as a Nyquist diagram of an orthogonal coordinate system or a polar coordinate system, and adapted to calculate the real intercepts of the impedance values for each of the battery cells or battery modules using the Nyquist diagram of the orthogonal coordinate system or the polar coordinate system.

3. The battery management system (100) according to claim 1 or 2, wherein the processor (120) is adapted to calculate a difference between a maximum value and a minimum value among the calculated real intercepts, and if the calculated difference is greater than a designated first reference value, adapted to determine that an abnormality has occurred in the secondary battery (10).

4. The battery management system (100) according to any one of claims 1 to 3, wherein the processor (120) is adapted to calculate a standard deviation of the calculated real intercepts, and if the calculated standard deviation is greater than a designated second reference value, adapted to determine that an abnormality has occurred in the secondary battery (10).

5. The battery management system (100) according to any one of claims 1 to 4, wherein the processor (120) is adapted to calculate a Z-score of the calculated real intercepts, and if the calculated Z-score is greater than a designated third reference value, adapted to determine that an abnormality has occurred in the secondary battery (10).

6. The battery management system (100) according to any one of claims 1 to 5, wherein the processor (120) is adapted to control the EIS measurement module (110) to measure the EIS during operation of a device including the secondary battery (10).

7. The battery management system (100) according to any one of claims 1 to 6, wherein the processor (120) is adapted to determine whether it is in a designated operation section,

wherein if it is in the designated operation section, adapted to determine whether the secondary battery (10) is abnormal based on the calculated real intercepts, and
if it is in another operation section except for the designated operation section, adapted to estimate an impedance of the secondary battery (10) using an equivalent circuit model (ECM) estimation module (140), and adapted to determine whether the secondary battery (10) is abnormal using the equivalent circuit model-based estimated result.

8. The battery management system (100) according to any one of claims 1 to 7, wherein the EIS measurement module (110) is adapted to apply a variable frequency in a designated range with a designated current amplitude to the secondary battery (10) as an input signal, and adapted to measure a voltage of the secondary battery (10).

9. A method for controlling a battery management system (100), the method comprising:

measuring an electrochemical impedance spectroscopy, EIS, of a secondary battery (10) through an EIS measurement module (110);
calculating real intercepts of impedance values for the secondary battery (10) based on the measured EIS;
determining whether the secondary battery (10) is abnormal based on the calculated real intercepts; and
controlling an alarm module (130) to provide an alarm notifying that the secondary battery (10) is abnormal if there is an abnormality in the secondary battery (10) as a result of the determination,
wherein the step of measuring the electrochemical impedance spectroscopy (EIS) comprises measuring an EIS for each battery cell or battery module, and wherein the method is **characterised in that** the step of calculating real intercepts comprises:

selecting a first point having a positive minimum value and a second point having a negative maximum value among imaginary parts of the impedance values for each of the battery cells or battery modules; and
calculating the real intercepts using coordinate values of the first point, coordinate values of the second point, and a designated equation.

10. The method according to claim 9, wherein the step of calculating real intercepts comprises:

expressing the impedance values for the secondary battery (10) as a Nyquist diagram of an orthogonal coordinate system or a polar coordinate system; and
calculating the real intercepts of the impedance values using the Nyquist diagram of the orthogonal coordinate system or the polar coordinate system.

11. The method according to claim 9 or 10, wherein the step of determining whether the secondary battery (10) is abnormal comprises:

calculating a difference between a maximum value and a minimum value among the calculated real intercepts; and

if the calculated difference is greater than a designated first reference value, determining that an abnormality has occurred in the secondary battery (10).

12. The method according to any one of claims 9 to 11, wherein the step of determining whether the secondary battery (10) is abnormal comprises:

calculating a standard deviation of the calculated real intercepts; and

if the calculated standard deviation is greater than a designated second reference value, determining that an abnormality has occurred in the secondary battery (10).

**Patentansprüche**

1. Batteriemanagementsystem (100), umfassend:

ein Alarmmodul (130), das dazu angepasst ist, einen Alarm in einer bestimmten Weise bereitzustellen;

ein elektrochemisches Impedanzspektroskopie-, EIS-, Messmodul (110), das dazu angepasst ist, eine EIS einer Sekundärbatterie (10) zu messen; und

einen Prozessor (120), der dazu angepasst ist, ein EIS-Messergebnis von dem EIS-Messmodul (110) zu empfangen, reale Abschnitte von Impedanzwerten für die Sekundärbatterie (10) basierend auf dem empfangenen EIS-Messergebnis zu berechnen, basierend auf den berechneten realen Abschnitten zu bestimmen, ob die Sekundärbatterie (10) anormal ist, und das Alarmmodul (130) zu steuern, um einen Alarm bereitzustellen, der benachrichtigt, dass die Sekundärbatterie (10) anormal ist, wenn eine Anormalität in der Sekundärbatterie (10) als ein Ergebnis der Bestimmung vorliegt,

wobei das EIS-Messmodul (110) dazu angepasst ist, die EIS für jede Batteriezelle oder jedes Batteriemodul zu messen, und

wobei das Batteriemanagementsystem **dadurch gekennzeichnet ist, dass** der Prozessor (120) dazu angepasst ist, einen ersten Punkt mit einem positiven Minimalwert und einen zweiten Punkt mit einem negativen Maximalwert unter imaginären Teilen der Impedanzwerte auszuwählen, und dazu angepasst ist, die realen Abschnitte unter Verwendung von Koordinatenwerten des ersten Punkts, Koordinatenwerten des zweiten Punkts und einer bestimmten Gleichung zu berechnen.

2. Batteriemanagementsystem (100) gemäß Anspruch 1, wobei der Prozessor (120) dazu angepasst ist, die Impedanzwerte für jede der Batteriezellen oder jedes der Batteriemodule als ein Nyquist-Diagramm eines orthogonalen Koordinatensystems oder eines polaren Koordinatensystems auszudrücken, und dazu angepasst ist, die realen Abschnitte der Impedanzwerte für jede der Batteriezellen oder jedes der Batteriemodule unter Verwendung des Nyquist-Diagramms des orthogonalen Koordinatensystems oder des polaren Koordinatensystems zu berechnen.

3. Batteriemanagementsystem (100) gemäß Anspruch 1 oder 2, wobei der Prozessor (120) dazu angepasst ist, eine Differenz zwischen einem Maximalwert und einem Minimalwert unter den berechneten realen Abschnitten zu berechnen, und, wenn die berechnete Differenz größer als ein bestimmter erster Referenzwert ist, dazu angepasst ist, zu bestimmen, dass eine Anormalität in der Sekundärbatterie (10) aufgetreten ist.

4. Batteriemanagementsystem (100) gemäß einem der Ansprüche 1 bis 3, wobei der Prozessor (120) dazu angepasst ist, eine Standardabweichung der berechneten realen Abschnitte zu berechnen, und, wenn die berechnete Standardabweichung größer als ein bestimmter zweiter Referenzwert ist, dazu angepasst ist, zu bestimmen, dass eine Anormalität in der Sekundärbatterie (10) aufgetreten ist.

5. Batteriemanagementsystem (100) gemäß einem der Ansprüche 1 bis 4, wobei der Prozessor (120) dazu angepasst ist, einen Z-Wert der berechneten realen Abschnitte zu berechnen, und, wenn der berechnete Z-Wert größer als ein bestimmter dritter Referenzwert ist, dazu angepasst ist, zu bestimmen, dass eine Anormalität in der Sekundärbatterie (10) aufgetreten ist.

6. Batteriemanagementsystem (100) gemäß einem der Ansprüche 1 bis 5, wobei der Prozessor (120) dazu angepasst ist, das EIS-Messmodul (110) zu steuern, um die EIS während des Betriebs einer Vorrichtung, die die Sekundärbatterie (10) beinhaltet, zu messen.

7. Batteriemanagementsystem (100) gemäß einem der Ansprüche 1 bis 6, wobei der Prozessor (120) dazu angepasst ist, zu bestimmen, ob er sich in einem bestimmten Betriebsabschnitt befindet,

wobei, wenn er sich in dem bestimmten Betriebsabschnitt befindet, er dazu angepasst ist, basierend auf den berechneten realen Abschnitten zu bestimmen, ob die Sekundärbatterie (10) anormal ist, und
wenn er sich in einem anderen Betriebsabschnitt mit Ausnahme des bestimmten Betriebsabschnitts befindet, er dazu angepasst ist, eine Impedanz der Sekundärbatterie (10) unter Verwendung eines Äquivalentschaltungsmodell- (ECM-) Schätzmoduls (140) zu schätzen, und er dazu angepasst ist, unter Verwendung des Schätzergebnisses basierend auf dem Äquivalentschaltungsmodell zu bestimmen, ob die Sekundärbatterie (10) anormal ist.

8. Batteriemanagementsystem (100) gemäß einem der Ansprüche 1 bis 7, wobei das EIS-Messmodul (110) dazu angepasst ist, eine variable Frequenz in einem bestimmten Bereich mit einer bestimmten Stromamplitude an die Sekundärbatterie (10) als ein Eingangssignal anzulegen, und dazu angepasst ist, eine Spannung der Sekundärbatterie (10) zu messen.

9. Verfahren zum Steuern eines Batteriemanagementsystems (100), wobei das Verfahren umfasst:

Messen einer elektrochemischen Impedanzspektroskopie, EIS, einer Sekundärbatterie (10) durch ein EIS-Messmodul (110);
Berechnen realer Abschnitte von Impedanzwerten für die Sekundärbatterie (10) basierend auf der gemessenen EIS;
Bestimmen, ob die Sekundärbatterie (10) anormal ist, basierend auf den berechneten realen Abschnitten; und
Steuern eines Alarmmoduls (130), um einen Alarm bereitzustellen, der benachrichtigt, dass die Sekundärbatterie (10) anormal ist, wenn eine Anormalität in der Sekundärbatterie (10) als ein Ergebnis der Bestimmung vorliegt,
wobei der Schritt des Messens der elektrochemischen Impedanzspektroskopie (EIS) das Messen einer EIS für jede Batteriezelle oder jedes Batteriemodul umfasst, und
wobei das Verfahren **dadurch gekennzeichnet ist, dass** der Schritt des Berechnens realer Abschnitte umfasst:

Auswählen eines ersten Punkts mit einem positiven Minimalwert und eines zweiten Punkts mit einem negativen Maximalwert unter imaginären Teilen der Impedanzwerte für jede der Batteriezellen oder jedes der Batteriemodule; und
Berechnen der realen Abschnitte unter Verwendung von Koordinatenwerten des ersten Punkts, Koordinatenwerten des zweiten Punkts und einer bestimmten Gleichung.

10. Verfahren gemäß Anspruch 9, wobei der Schritt des Berechnens realer Abschnitte umfasst:

Ausdrücken der Impedanzwerte für die Sekundärbatterie (10) als ein Nyquist-Diagramm eines orthogonalen Koordinatensystems oder eines polaren Koordinatensystems; und
Berechnen der realen Abschnitte der Impedanzwerte unter Verwendung des Nyquist-Diagramms des orthogonalen Koordinatensystems oder des polaren Koordinatensystems.

11. Verfahren gemäß Anspruch 9 oder 10, wobei der Schritt des Bestimmens, ob die Sekundärbatterie (10) anormal ist, umfasst:

Berechnen einer Differenz zwischen einem Maximalwert und einem Minimalwert unter den berechneten realen Abschnitten; und
wenn die berechnete Differenz größer als ein bestimmter erster Referenzwert ist, Bestimmen, dass eine Anormalität in der Sekundärbatterie (10) aufgetreten ist.

12. Verfahren gemäß einem der Ansprüche 9 bis 11, wobei der Schritt des Bestimmens, ob die Sekundärbatterie (10) anormal ist, umfasst:

Berechnen einer Standardabweichung der berechneten realen Abschnitte; und
wenn die berechnete Standardabweichung größer als ein bestimmter zweiter Referenzwert ist, Bestimmen, dass eine Anormalität in der Sekundärbatterie (10) aufgetreten ist.

**Revendications**

1. Système de gestion de batterie (100) comprenant :

   un module d'alarme (130) configuré pour fournir une alarme d'une manière désignée ;
   un module de mesure de spectroscopie d'impédance électrochimique, SIE, (110) configuré pour mesurer une SIE d'une batterie secondaire (10) ; et
   un processeur (120) configuré pour recevoir un résultat de mesure d'SIE du module de mesure d'SIE (110), calculer des interceptions réelles de valeurs d'impédance pour la batterie secondaire (10) sur la base du résultat de mesure d'SIE reçu, déterminer si la batterie secondaire (10) est anormale sur la base des interceptions réelles calculées, et commander le module d'alarme (130) pour fournir une alarme notifiant que la batterie secondaire (10) est anormale s'il y a une anomalie dans la batterie secondaire (10) à la suite de la détermination,

   où le module de mesure d'SIE (110) est adapté pour mesurer l'SIE pour chaque élément de batterie ou module de batterie, et
   où le système de gestion de batterie est **caractérisé en ce que** le processeur (120) est adapté pour sélectionner un premier point ayant une valeur minimale positive et un deuxième point ayant une valeur maximale négative parmi des parties imaginaires des valeurs d'impédance, et est adapté pour calculer les interceptions réelles en utilisant des valeurs de coordonnées du premier point, des valeurs de coordonnées du deuxième point, et une équation désignée.

2. Système de gestion de batterie (100) selon la revendication 1, où le processeur (120) est adapté pour exprimer les valeurs d'impédance pour chacun des éléments de batterie ou modules de batterie en tant que diagramme de Nyquist d'un système de coordonnées orthogonales ou d'un système de coordonnées polaires, et adapté pour calculer les interceptions réelles des valeurs d'impédance pour chacun des éléments de batterie ou modules de batterie en utilisant le diagramme de Nyquist du système de coordonnées orthogonales ou du système de coordonnées polaires.

3. Système de gestion de batterie (100) selon la revendication 1 ou 2, où le processeur (120) est adapté pour calculer une différence entre une valeur maximale et une valeur minimale parmi les interceptions réelles calculées, et si la différence calculée est supérieure à une première valeur de référence désignée, adapté pour déterminer qu'une anomalie s'est produite dans la batterie secondaire (10).

4. Système de gestion de batterie (100) selon l'une quelconque des revendications 1 à 3, où le processeur (120) est adapté pour calculer un écart-type des interceptions réelles calculées, et si l'écart-type calculé est supérieur à une deuxième valeur de référence désignée, adapté pour déterminer qu'une anomalie s'est produite dans la batterie secondaire (10).

5. Système de gestion de batterie (100) selon l'une quelconque des revendications 1 à 4, où le processeur (120) est adapté pour calculer un score Z des interceptions réelles calculées, et si le score Z calculé est supérieur à une troisième valeur de référence désignée, adapté pour déterminer qu'une anomalie s'est produite dans la batterie secondaire (10).

6. Système de gestion de batterie (100) selon l'une quelconque des revendications 1 à 5, où le processeur (120) est adapté pour commander le module de mesure d'SIE (110) pour mesurer l'SIE pendant le fonctionnement d'un dispositif incluant la batterie secondaire (10).

7. Système de gestion de batterie (100) selon l'une quelconque des revendications 1 à 6, où le processeur (120) est adapté pour déterminer s'il est dans une section de fonctionnement désignée,

   où s'il est dans la section de fonctionnement désignée, adapté pour déterminer si la batterie secondaire (10) est anormale sur la base des interceptions réelles calculées, et
   s'il est dans une autre section de fonctionnement à l'exception de la section de fonctionnement désignée, adapté pour estimer une impédance de la batterie secondaire (10) en utilisant un module d'estimation de modèle de circuit équivalent (ECM) (140), et adapté pour déterminer si la batterie secondaire (10) est anormale en utilisant le résultat estimé basé sur le modèle de circuit équivalent.

8. Système de gestion de batterie (100) selon l'une quelconque des revendications 1 à 7, où le module de mesure d'SIE (110) est adapté pour appliquer une fréquence variable dans une plage désignée avec une amplitude de courant désignée à la batterie secondaire (10) en tant que signal d'entrée, et adapté pour mesurer une tension de la batterie secondaire (10).

9. Procédé de commande d'un système de gestion de batterie (100), le procédé comprenant :

la mesure d'une spectroscopie d'impédance électrochimique, SIE, d'une batterie secondaire (10) par l'intermédiaire d'un module de mesure d'SIE (110) ;
le calcul d'interceptions réelles de valeurs d'impédance pour la batterie secondaire (10) sur la base de l'SIE mesurée ;
la détermination si la batterie secondaire (10) est anormale sur la base des interceptions réelles calculées ; et
la commande d'un module d'alarme (130) pour fournir une alarme notifiant que la batterie secondaire (10) est anormale s'il y a une anomalie dans la batterie secondaire (10) à la suite de la détermination,

où l'étape de mesure de la spectroscopie d'impédance électrochimique (SIE) comprend la mesure d'une SIE pour chaque élément de batterie ou module de batterie, et
où le procédé est **caractérisé en ce que** l'étape de calcul d'interceptions réelles comprend :

la sélection d'un premier point ayant une valeur minimale positive et d'un deuxième point ayant une valeur maximale négative parmi des parties imaginaires des valeurs d'impédance pour chacun des éléments de batterie ou modules de batterie ; et
le calcul des interceptions réelles en utilisant des valeurs de coordonnées du premier point, des valeurs de coordonnées du deuxième point, et une équation désignée.

10. Procédé selon la revendication 9, où l'étape de calcul d'interceptions réelles comprend :

l'expression des valeurs d'impédance pour la batterie secondaire (10) en tant que diagramme de Nyquist d'un système de coordonnées orthogonales ou d'un système de coordonnées polaires ; et
le calcul des interceptions réelles des valeurs d'impédance en utilisant le diagramme de Nyquist du système de coordonnées orthogonales ou du système de coordonnées polaires.

11. Procédé selon la revendication 9 ou 10, où l'étape de détermination si la batterie secondaire (10) est anormale comprend :

le calcul d'une différence entre une valeur maximale et une valeur minimale parmi les interceptions réelles calculées ; et
si la différence calculée est supérieure à une première valeur de référence désignée, la détermination qu'une anomalie s'est produite dans la batterie secondaire (10).

12. Procédé selon l'une quelconque des revendications 9 à 11, où l'étape de détermination si la batterie secondaire (10) est anormale comprend :

le calcul d'un écart-type des interceptions réelles calculées ; et
si l'écart-type calculé est supérieur à une deuxième valeur de référence désignée, la détermination qu'une anomalie s'est produite dans la batterie secondaire (10).

[FIG. 1]

[FIG. 2]

```
                          ( Start )
                              │
                              ▼
        ┌─────────────────────────────────────┐
        │      Measure EIS for each component  │
        │        of secondary battery          │── S210
        └─────────────────────────────────────┘
                              │
                              ▼
        ┌─────────────────────────────────────┐── S220
        │        Calculate real intercepts of  │
        │          impedance values for each   │
        │   component of secondary battery based│
        │            on measured EIS           │
        └─────────────────────────────────────┘
                              │
                              ▼
    No                   ◇─────────────────◇
abnormality    ◇─────  Determine whether    ─────◇── S230
      ◄────────  secondary battery is abnormal based
      │              ◇      on calculated
      │                     real intercepts   ◇
      │                 ◇─────────────────◇
      │                          │
      │                  Abnormality
      │                   occurred
      │                          ▼
      │        ┌─────────────────────────────────────┐
      │        │ Alarm notifying that there is abnormality │── S240
      │        │   in at least one of components      │
      │        │       of secondary battery           │
      │        └─────────────────────────────────────┘
      │                          │
      └──────────────────────────┤
                                 ▼
                            ( End )
```

[FIG. 3A]

[FIG. 3B]

[FIG. 4]

[FIG. 5]

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

• KR 20220054127 A